(19) Europäisches Patentamt
European Patent Office
Office européen des brevets

(11) EP 2 730 929 B1

(12) FASCICULE DE BREVET EUROPEEN

(45) Date de publication et mention de la délivrance du brevet:
**04.03.2015 Bulletin 2015/10**

(51) Int Cl.:
***G01R 15/18*** *(2006.01)*    *G01R 31/06* *(2006.01)*

(21) Numéro de dépôt: **13191995.3**

(22) Date de dépôt: **07.11.2013**

(54) **Procédé et système de détermination de la tension primaire d'un transformateur, et poste de transformation comportant un tel système de détermination**

Verfahren und System zur Bestimmung der Primärspannung eines Transformators und Trafostation, die ein solches Bestimmungssystem umfasst

Method and system for determining the primary voltage of a transformer, and transforming station comprising such a determination system

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.11.2012 FR 1260655**

(43) Date de publication de la demande:
**14.05.2014 Bulletin 2014/20**

(73) Titulaire: **Schneider Electric Industries SAS 92500 Rueil-Malmaison (FR)**

(72) Inventeurs:
• **Deschamps, Philippe 38800 LE PONT DE CLAIX (FR)**
• **Boss, Denis 57000 METZ (FR)**

(74) Mandataire: **Myon, Gérard Jean-Pierre et al Cabinet Lavoix 62, rue de Bonnel 69003 Lyon (FR)**

(56) Documents cités:
**WO-A1-02/097455    US-A1- 2012 061 964**

## Description

La présente invention concerne un procédé de détermination de la tension primaire d'un transformateur électrique, le transformateur électrique présentant un rapport de transformation à vide et comprenant un enroulement primaire propre à présenter la tension primaire entre ses extrémités et à être traversé par un courant primaire, un enroulement secondaire propre à présenter une tension secondaire entre ses extrémités et à être traversé par un courant secondaire.

Ce procédé comprend les étapes suivantes :

- la mesure de la tension secondaire à l'aide d'un capteur de tension,
- la mesure du courant primaire à l'aide d'un premier capteur de courant.

L'invention concerne également un système de détermination de la tension primaire d'un transformateur électrique destiné à mettre en oeuvre un tel procédé.

La distribution terminale des réseaux de distribution publique d'un courant polyphasé vers des consommateurs d'énergie est réalisée en basse tension depuis des postes moyenne tension / basse tension, également appelés postes MT/BT. Chaque poste MT/BT est en forme d'une structure radiale comportant une pluralité de lignes basse tension, chacune desservant un certain nombre de consommateurs. Chaque ligne basse tension comporte un conducteur de phase pour chaque phase du courant polyphasé délivré et un conducteur de neutre. Chacun de ces postes MT/BT est lui-même connecté sur une ligne moyenne tension dont l'origine se trouve sur un poste haute tension / moyenne tension, également appelé poste HT/MT.

La basse tension est susceptible de varier en fonction des charges connectées au réseau basse tension et des caractéristiques des lignes basse tension. Le contrôle de la conformité de la tension délivrée est assuré suivant deux méthodes.

Une première méthode consiste, en phase de conception du réseau, au calcul du dimensionnement des câbles et de la répartition des charges, afin de garantir une chute de tension minimale dans les conducteurs compatible avec les limites de tension admissibles par les charges.

Une deuxième méthode, réalisable en condition d'exploitation, consiste au réglage de la tension sur les lignes basse tension pour s'adapter aux conditions du moment. Cette deuxième méthode comprend également l'ajustement de la tension en amont. D'une part, des régleurs en charge des postes HT/MT, pilotés automatiquement et en permanence, permettent d'ajuster la tension en tête de réseau pour minimiser les pertes en ligne tout en conservant une tension acceptable en aval. D'autre part, des régleurs hors charge des postes MT/BT permettent d'ajuster la tension en amont. Ces régleurs hors charge comportent des commutateurs manuels, également appelés organes de réglage, disposés dans les transformateurs de distribution. Ils permettent de choisir l'enroulement le plus adapté du transformateur en fonction de la structure du réseau auquel il est relié. Les régleurs hors charge sont manoeuvrés très occasionnellement, c'est-à-dire quelques fois pendant toute la durée de vie du transformateur, pour suivre les évolutions structurelles du réseau et des consommateurs.

Dans ce contexte, l'insertion d'une production décentralisée dans le réseau, en particulier basse tension, provoque localement des dépassements de la tension maximale. En effet, le dimensionnement du réseau, calculé lors de sa conception, ne prend pas en compte les flux d'énergie issus des productions décentralisées. Il est alors nécessaire de surveiller régulièrement le courant circulant dans l'enroulement primaire du transformateur, également appelé courant primaire, la tension entre les extrémités de l'enroulement primaire, également appelée tension primaire, le courant circulant dans l'enroulement secondaire du transformateur, également appelé courant secondaire, et la tension entre les extrémités de l'enroulement secondaire, également appelée tension secondaire.

On connaît l'existence de solutions simples et économiques pour mesurer le courant primaire et/ou le courant secondaire, par exemple à l'aide de tores ouvrants. On connait également des solutions pour mesurer la tension secondaire.

US 2010/061964 A1 décrit un système électrique comprenant une ligne moyenne tension, une ligne haute tension et un transformateur adapté pour transformer la moyenne tension en haute tension. Le système comprend également un dispositif de contrôle comportant une unité d'évaluation connectée à un dispositif de mesure de grandeurs relatives à la moyenne tension. L'unité d'évaluation est propre à déterminer des caractéristiques de la haute tension à partir des valeurs mesurées relatives à la moyenne tension et en fonction d'un modèle du transformateur.

Pour la mesure de la tension primaire, on connaît l'utilisation de transformateurs de mesure en tension, de diviseurs capacitifs, de diviseurs résistifs, ou encore des solutions basées sur un calcul simplifié qui est fonction de la tension secondaire et du rapport de transformation du transformateur.

Toutefois, de telles mesures de la tension primaire sont peu précises ou trop coûteuses, notamment dans le cas du transformateur de mesure en tension. Elles sont également intrusives car nécessitent d'accéder aux parties sous tension du circuit primaire du transformateur ou des câbles qui y sont raccordés.

Le but de l'invention est donc de proposer un procédé de détermination de la tension primaire d'un transformateur plus précis, tout en étant de coût limité et compatible avec le parc existant de postes MT/BT.

A cet effet, l'invention a pour objet un procédé, selon la revendication 1, de détermination de la tension primaire d'un transformateur

Suivant d'autres aspects avantageux de l'invention, le procédé de détermination comprend une ou plusieurs des caractéristiques suivantes, prises isolement ou suivant toutes les combinaisons techniquement possibles, selon les revendications dépendantes 2 à 7.

L'invention a également pour objet un système, selon la revendication 8, de détermination de la tension primaire d'un transformateur électrique.

Suivant d'autres aspects avantageux de l'invention, le système de détermination comprend une ou plusieurs des caractéristiques suivantes, prise isolement ou suivant toutes les combinaisons techniquement possibles, selon les revendications dépendantes 9 et 10.

L'invention a également pour objet un poste, selon la revendication 11, de transformation d'un premier courant électrique présentant une première tension alternative en un deuxième courant électrique présentant une deuxième tension alternative.

Ces caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique d'un poste de transformation comprenant un premier tableau, un deuxième tableau connecté au premier tableau par l'intermédiaire d'un transformateur et un système de détermination de la tension primaire à partir des mesures de courants primaire et secondaire et de la tension secondaire,
- la figure 2 est une vue détaillée représentant la communication entre une unité de traitement d'informations du système de détermination et les capteurs de courant secondaire et de tension secondaire visibles sur la figure 1,
- la figure 3 est un organigramme d'un procédé de détermination de la tension primaire d'un transformateur, selon l'invention.

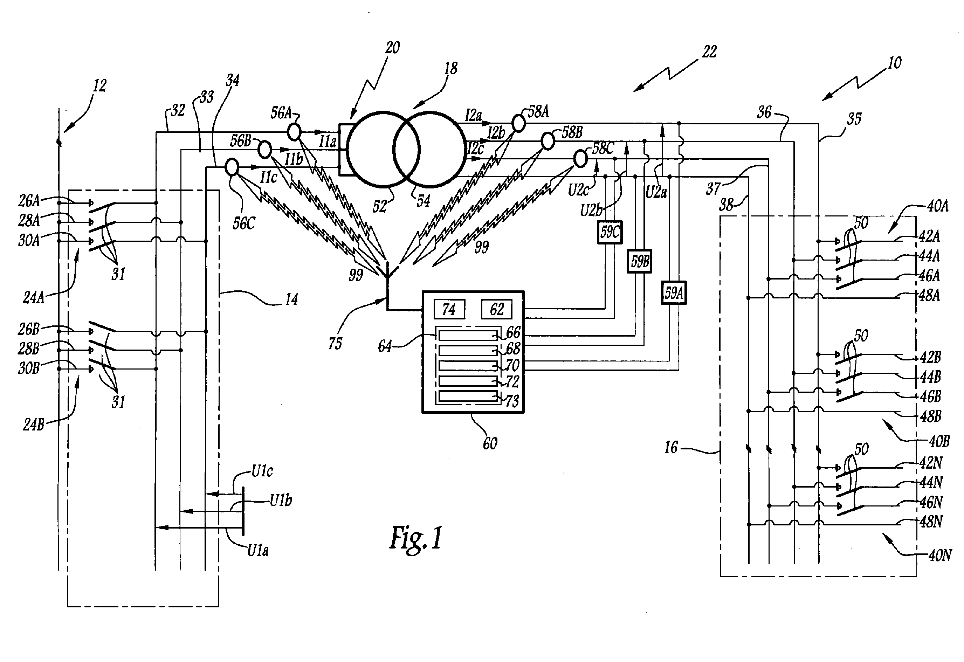

Sur la figure 1, un poste de transformation 10 connecté à un réseau électrique alternatif 12 comprend un premier tableau 14, un deuxième tableau 16, un transformateur électrique 18 muni d'un organe de réglage 20 et connecté entre le premier tableau et le deuxième tableau, ainsi qu'un système 22 de détermination d'une tension primaire $U1j$ du transformateur 18.

Le poste de transformation 10 est propre à transformer le courant électrique $I1j$ délivré par le réseau 12 et présentant une première tension alternative $U1j$, en un courant électrique $I2j$ présentant une deuxième tension alternative $U2j$.

Le réseau électrique 12 est un réseau alternatif comprenant P phases, P étant un nombre entier supérieur ou égal à 1, tel qu'un réseau triphasé. Autrement dit, dans le mode de réalisation décrit à la figure 1, P est égal à 3 Les tensions $U1j$, $U2j$ et courants $I1j$, $I2j$ de chaque conducteur de phase sont $U1a$, $U1b$, $U1c$, $U2a$, $U2b$, $U2c$ et $I1a$, $I1b$, $I1c$, $I2a$, $I2b$, $I2c$.

Le réseau électrique 12 est un réseau moyenne tension, c'est-à-dire un réseau dont la tension est supérieure à 1000 V et inférieure à 50 000 V. La première tension triphasée $U1j$ est alors une moyenne tension.

Le premier tableau 14 comporte plusieurs arrivées 24A, 24B, chaque arrivée 24A, 24B comportant un premier 26A, 26B, un deuxième 28A, 28B et un troisième 30A, 30B conducteur d'arrivée. Chaque conducteur d'arrivée 26A, 26B, 28A, 28B, 30A, 30B est relié au réseau électrique 12 par l'intermédiaire par exemple d'un disjoncteur d'arrivée 31 respectif. Le courant triphasé $I1j$ circulant dans les conducteurs d'arrivée 26A, 26B, 28A, 28B, 30A, 30B correspondants présente la première tension triphasée $U1j$.

Les premiers conducteurs d'arrivée 26A, 26B, les deuxièmes conducteurs d'arrivée 28A, 28B, les troisièmes conducteurs d'arrivée 30A, 30B sont connectés respectivement à un premier conducteur primaire de liaison 32, un deuxième conducteur primaire de liaison 33 et un troisième conducteur primaire de liaison 34. Ces conducteurs primaires de liaison relient les arrivées 24 à l'organe de réglage 20 du transformateur 18.

Le deuxième tableau 16 comprend un premier 35, un deuxième 36, un troisième 37, et un quatrième 38 conducteurs secondaires de liaison et une pluralité N de départs 40A, 40B, ..., 40N, à savoir un premier départ 40A, un deuxième départ 40B, ..., un Nième départ 40N, chaque départ 40A, 40B, ..., 40N étant propre à délivrer une tension triphasée $U2j$. Les conducteurs secondaires de liaison 35, 36, 37, 38 relient le transformateur 18 aux départs 40A, ..., 40N.

Chaque départ 40A, ..., 40N est un départ basse tension $U2j$, c'est-à-dire un départ dont la tension est inférieure à 1000 Volts. La deuxième tension triphasée $U2j$ est alors une basse tension.

Le premier départ 40A comporte un premier 42A, un deuxième 44A, un troisième 46A et un quatrième 48A conducteurs de départ et trois disjoncteurs de départ 50. Les premier, deuxième, troisième conducteurs de départ 42A, 42B, 42C sont respectivement reliés aux premier, deuxième et troisième conducteurs secondaires de liaison 35, 36, 37 par l'intermédiaire d'un disjoncteur de départ 50 correspondant. Le quatrième conducteur de départ 48A est directement connecté au quatrième conducteur secondaire de liaison 38.

Les conducteurs secondaires de liaison 35, 36, 37 et les conducteurs de départ des départs 42A, 44A, 46A correspondants présentent la même tension U2j, chacune correspondant à une phase respective U2a, U2b, U2c de la deuxième tension triphasée.

Les autres départs 40B, ..., 40N sont identiques au premier départ 40A décrit précédemment, et comportent les mêmes éléments en remplaçant à chaque fois la lettre A par la lettre B, ..., N correspondante concernant les références des éléments.

Le transformateur électrique 18 est propre à transformer le courant I1j issu du réseau électrique présentant la première tension alternative U1j en le courant I2j délivré au deuxième tableau 16 et présentant la deuxième tension alternative U2j. Le transformateur électrique 18 comporte un enroulement primaire 52 connecté au premier tableau 14 et un enroulement secondaire 54 connecté au deuxième tableau 16, chaque enroulement 52, 54 comportant une bobine électromagnétique, non représentée, pour chaque phase a, b, c du courant alternatif correspondant.

Le courant propre à circuler dans l'enroulement primaire 52 du transformateur est appelé courant primaire et est noté I1j, j étant l'indice de la phase correspondante, égal à a, b ou c. La tension entre les extrémités de l'enroulement primaire 52 est appelée tension primaire et est noté U1j pour chaque phase j du courant alternatif correspondant. Le courant propre à circuler dans l'enroulement secondaire 54 du transformateur est appelé courant secondaire I2j, et la tension entre les extrémités de l'enroulement secondaire 54 est appelée tension secondaire U2j pour chaque phase j du courant alternatif correspondant, j étant égal à a, b ou c.

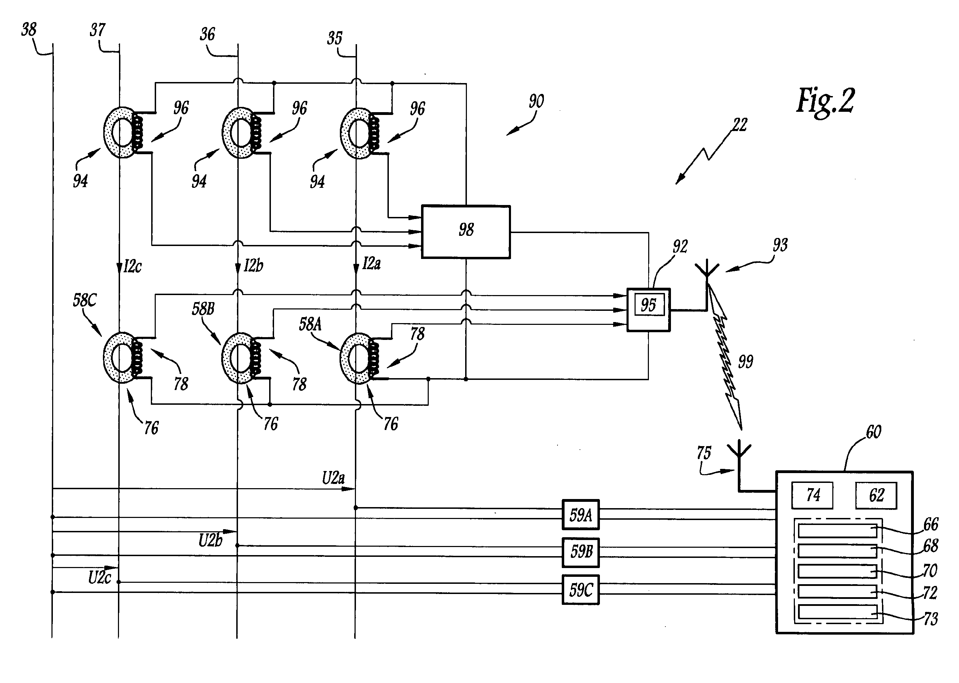

Le système de détermination 22, visible sur la figure 1 et dont une partie est visible à plus grande échelle sur la figure 2, comprend des capteurs 56A, 56B, 56C du courant primaire, des capteurs 58A, 58B, 58C du courant secondaire, des capteurs 59A, 59B, 59C de la tension secondaire, ainsi qu'une unité de traitement d'information 60.

Le système de détermination 22 est propre à mesurer, à l'aide des capteurs de courant primaire 56A, 56B, 56C, les courants primaires I1a, I1b, I1c traversant chacun des trois conducteurs primaires de liaison 32, 33, 34 reliés à l'enroulement primaire 52 du transformateur.

Le système de détermination 22 est propre à mesurer, à l'aide des capteurs de courant secondaire 58A, 58B, 58C, les courants secondaires I2a, I2b, I2c traversant chacun des trois conducteurs secondaires de liaison 35, 36, 37 reliés à l'enroulement secondaire 54 du transformateur.

Le système de détermination 22 est propre à mesurer, à l'aide des capteurs de tension 59A, 59B, 59C, les tensions secondaires U2a, U2b, U2c, par rapport au conducteur de neutre 38, de chacun des trois conducteurs secondaires de liaison 35, 36, 37 reliés à l'enroulement secondaire 54.

L'unité de traitement d'information 60 comprend un processeur 62 et une mémoire 64 associée au processeur 62. La mémoire 64 est apte à stocker un premier logiciel 66 de calcul de la chute de tension $\frac{\Delta U}{U}$ aux bornes du transformateur du côté de l'enroulement secondaire 54, un deuxième logiciel 68 de calcul du module de la tension primaire U1a, U1b, U1c du transformateur et un troisième logiciel 70 de calcul du déphasage de la tension primaire U1a, U1b, U1c avec le courant primaire I1a, I1b, I1c.

L'unité de traitement de l'information 60 comprend un logiciel de communication 72 propre à communiquer avec les capteurs de courant 56A, ..., 58C.

L'unité de traitement comprend un logiciel 73 d'acquisition des valeurs mesurées par les capteurs de courant primaire 56A, 56B, 56C, les capteurs de courant secondaire 58A, 58B, 58C et les capteurs de tension secondaire 59A, 59B, 59C.

Ces cinq logiciels 66, 68, 70, 72, 73 sont aptes à communiquer entre eux.

Le premier logiciel de calcul 66 est propre à calculer la chute de tension $\frac{\Delta U}{U}$ à partir de l'équation [1]

$$[1] \quad \frac{\Delta U}{U} = (Ur \cos\varphi + Ux \sin\varphi).n \; + \; \frac{1}{200} \; (Ux \cos\varphi \; - \; Ur \sin\varphi) \; . \; n^2$$

où Ur et Ux représentent les composantes résistives et réactives propres au transformateur 18, n représente le facteur de charge du transformateur 18 et cosφ représente le facteur de puissance de la charge du transformateur 18.

Le deuxième logiciel de calcul 68 est propre à calculer le module de la tension primaire à partir de l'équation [2] :

$$[2] \qquad U1j = Kpos.\frac{U1o}{U2o}.\frac{U2j}{1 - \dfrac{\Delta U}{U}}$$

où Kpos est un coefficient dépendant de la position de l'organe de réglage 20, $\dfrac{U1o}{U2o}$ est le rapport de transformation à vide du transformateur 18, U2j est la tension secondaire mesurée et $\dfrac{\Delta U}{U}$ la chute de tension précédemment calculée à l'aide de l'équation [1].

Le deuxième logiciel de calcul 68 du module de la tension primaire est propre à déterminer le coefficient Kpos dépendant de la position de l'organe de réglage dans une étape préliminaire au calcul de l'équation [2].

Cette étape préliminaire permet de déduire la position de l'organe de réglage à partir de la connaissance des tensions nominales primaire pour chacune des positions de l'organe de réglage du transformateur, de la tension nominale secondaire, et de l'équation [3] :

$$[3] \qquad \frac{I2j}{I1j} = \frac{U1j}{U2j}$$

où I1j et I2j sont les courants primaires et secondaires mesurés, U1j et U2j sont les tensions primaires et secondaires.

Chaque position de l'organe de réglage détermine une tension primaire, donc un rapport entre les tensions primaires et secondaires. Ce rapport entre les tensions primaire et secondaires est égal au rapport entre les courants secondaires et primaires mesurés. La détermination de la position de l'organe de mesure lors de cette étape préliminaire consiste donc à identifier le rapport entre les tensions primaires et secondaires, via les courants mesurés, et donc d'en déduire la position de l'organe de réglage.

Le troisième logiciel de calcul 70 est propre à calculer le déphasage de la tension primaire U1j avec le courant primaire I1j pour une configuration D yn11 du transformateur 18 à partir de l'équation [4]

$$[4] \qquad ph(U1j,I1j) = \pi - ph(I1j,U2j)$$

où I1j est le courant primaire mesuré pour chaque phase j, U2j la tension secondaire mesurée pour chaque phase j, U1j la tension primaire pour chaque phase j et ph(I1j,U2j) le déphasage entre le courant primaire I1j et la tension secondaire U2j pour chaque phase j. La configuration D yn11 du transformateur 18 correspond à un système triphasé avec les bobines de l'enroulement primaire 52 connectées en triangle et les bobines de l'enroulement secondaire 54 connectées en étoile avec neutre sorti.

Dans l'exemple de réalisation des figures 1 et 2, la communication entre les capteurs de courant 56A, ..., 58C et l'unité de traitement de l'information 60 se fait par communication radioélectrique. L'unité de traitement de l'information 60 comprend alors un émetteur-récepteur radioélectrique 74 et une antenne radioélectrique 75.

Le système de détermination 22 est propre à déterminer la tension primaire U1j du transformateur électrique 18 à partir des mesures des courants primaire I1j et secondaire 12j, ainsi que de la tension secondaire U2j.

Sur la figure 2, chaque capteur de courant secondaire 58A, 58B, 58C comporte un premier tore 76 disposé autour de chacun des conducteurs secondaires de liaison 35, 36, 37 et un premier enroulement 78 agencé autour du premier tore 76, comme représenté sur la figure 2. La circulation du courant I2a, I2b, 12c à travers le conducteur secondaire de liaison 35, 36, 37 correspondant est propre à engendrer un courant induit proportionnel à l'intensité du courant dans le premier enroulement 78. Le premier tore 76 est, par exemple, un tore de Rogowski. Le premier tore 76 est de préférence un tore ouvrant afin de faciliter son agencement autour des conducteurs 35, 36, 37 correspondants.

Pour chaque capteur de courant 58A, 58B, 58C, la circulation du courant I2a, I2b, 12c à travers le conducteur secondaire de liaison 35, 36, 37 correspondant est propre à engendrer un signal proportionnel à l'intensité du courant dans le premier enroulement 78.

Les capteurs de courant primaire 56A, 56B, 56C sont identiques aux capteurs de courant secondaire 58A, 58B, 58C décrits sur la figure 2.

Un organe d'alimentation 90, visible sur la figure 2, est propre à alimenter une unité de communication 92 propre à mettre en forme les courants secondaires mesurés I2j et les communiquer à l'unité de traitement d'informations 60 via une antenne radioélectrique 93. L'organe d'alimentation 90 comporte, pour chacun des premier, deuxième et troisième conducteurs secondaires de liaison 35, 36, 37, un deuxième tore 94 disposé autour du conducteur secondaire de liaison 35, 36, 37 correspondant et un deuxième enroulement 96 agencé autour du deuxième tore 94. La circulation du courant dans le conducteur secondaire de liaison 35, 36, 37 correspondant est propre à engendrer un courant induit dans le deuxième enroulement 96.

L'organe d'alimentation 90 comporte un convertisseur 98 connecté à chacun des deuxièmes enroulements 96 et propre à délivrer une tension prédéterminée à l'unité de communication 92. Chaque deuxième tore 94 est un tore en fer. Chaque deuxième tore 94 est de préférence un tore ouvrant afin de faciliter son agencement autour des conducteurs 35, 36, 37 correspondants.

Autrement dit, la transmission des mesures du courant secondaire I2j est autoalimentée par l'intermédiaire de l'organe d'alimentation 90 comportant les deuxièmes tores 94 adaptés pour récupérer l'énergie magnétique issue de la circulation du courant dans les conducteurs secondaires de liaison 35, 36, 37 correspondants.

L'unité de traitement d'informations 60 est propre à communiquer avec les capteurs de courant primaire 56A, 56B, 56C, les capteurs de tension secondaire 59A, 59B, 59C, ainsi qu'avec les capteurs de courant secondaire 58A, 58B, 58C via l'unité de communication 92 et l'antenne 93.

Dans l'exemple de réalisation de la figure 2, la transmission des mesures de courant I2a, I2b, I2c à destination de l'unité de traitement d'information 60 est effectuée à l'aide d'un émetteur-récepteur 95 inclus dans l'unité de communication, et de l'antenne radioélectrique 93 via une liaison radioélectrique de données 99.

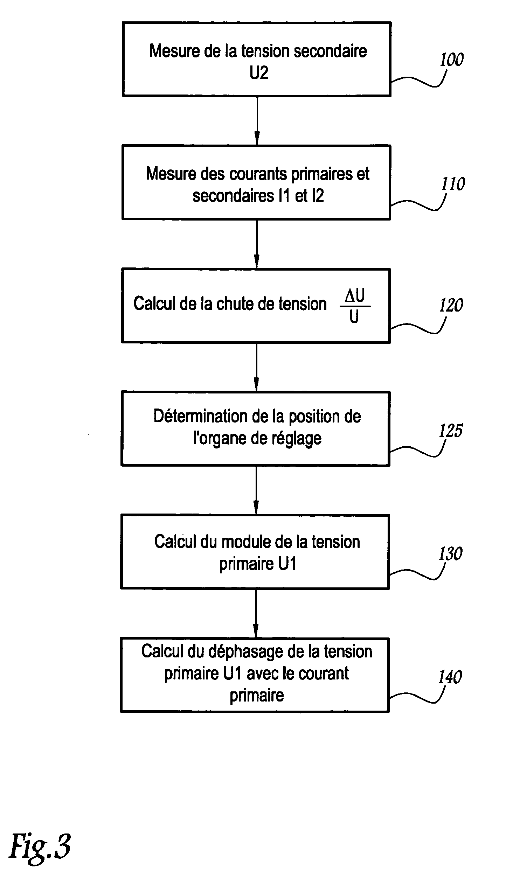

Le fonctionnement du système de détermination de la tension primaire U1j du transformateur 18 va désormais être expliqué à l'aide de la figure 3. La figure 3 représente un organigramme des étapes d'un procédé de détermination de la tension primaire U1j du transformateur 18 mises en oeuvre par le système de détermination 22, notamment par les capteurs de courant primaire 56A, 56B, 56C et secondaire 58A, 58B, 58C, les capteurs de tension secondaire 59A, 59B, 59C, ainsi que par l'unité de traitement d'informations 60.

Sur la figure 3, lors d'une première étape 100, les capteurs de tension secondaire 59A, 59B, 59C mesurent les tensions secondaires U2j, j étant par exemple égal à a, b, c, de chacun des premier, deuxième et troisième conducteurs secondaires de liaison 35, 36, 37 par rapport au quatrième conducteur secondaire de liaison 38, c'est-à-dire le conducteur de neutre. Ces tensions U2a, U2b, U2c sont communiquées à l'unité de traitement d'informations 60.

Lors d'une deuxième étape 110, les capteurs de courant primaire 56A, 56B, 56C et les capteurs de courant secondaire 58A, 58B, 58C mesurent les courants primaires I1a, I1b, I1c et secondaires I2a, I2b, 2c de part et d'autre du transformateur 18 à l'aide du système de détermination 22 décrit à la figure 2. Lors de cette étape 110, les capteurs de courant primaire et secondaire 56A, 56B, 56C, 58A, 58B, 58C transmettent les mesures de courant via la liaison de données 99, telle qu'une liaison radioélectrique, à l'unité de traitement d'informations 60.

Les mesures de courant sont reçues par le logiciel de communication 72 et prises en compte par le logiciel d'acquisition 73, afin d'être ensuite délivrées aux logiciels de calcul 66, 68, 70. Une fois les mesures des courants primaires I1a, I1b, I1c, des courants secondaires I2a, I2b, 12c et des tensions secondaires U2a, U2b, U2c centralisées dans l'unité de traitement d'informations 60, celle-ci peut à l'aide des logiciels de calcul 66, 68, 70, réaliser les étapes de calcul permettant de déterminer les tensions primaires U1a, U1b, U1c correspondantes du transformateur 18.

Dans une première étape de calcul 120, le premier logiciel de calcul 66 réalise le calcul de la chute de tension aux bornes du transformateur 18, du côté de l'enroulement secondaire 54.

Le calcul de cette chute de tension se fait à partir des données des composantes résistive Ur et réactive Ux de la tension de court-circuit mesurée en essai sur le transformateur 18, du facteur de charge du transformateur 18 et du facteur de puissance de la charge du transformateur 18. Cette chute de tension est calculée à partir de l'équation [1]. Elle est exprimée en pourcentage de la tension nominale à vide, cette dernière étant indiquée sur une plaque signalétique, non représentée, associée au transformateur 18.

Les mesures complémentaires du facteur de charge du transformateur, c'est-à-dire la mesure du courant secondaire I2j, et celles du facteur de puissance cosφ de la charge seront également prises en compte par l'unité de traitement d'informations 60 pour la détermination de la chute de tension pour le régime de charge considéré.

Après cette étape 120 et une étape intermédiaire 125 de détermination de la position de l'organe de réglage Kpos, le deuxième logiciel de calcul 68 calcule, lors d'une deuxième étape de calcul 130, le module de la tension primaire U1j à partir de l'équation [2].

Lors de l'étape intermédiaire 125, la position de l'organe de réglage Kpos est déterminée en fonction du nombre de spires de l'enroulement primaire 52 pris en compte. En général, un organe de réglage 20 comprend une pluralité de positions de réglage, telles qu'une première P1, une deuxième P2 et une troisième P3 positions lorsque le transformateur électrique 18 est utilisé en France. La deuxième position P2 est la position pour laquelle on obtient une tension nominale. La sélection de la première position P1 permet la pris en compte d'un nombre de spires plus important, donc l'établissement d'une tension primaire U1j plus importante. Inversement, la sélection de la troisième position P3 entraîne la prise en compte d'un nombre de spires moins important et impose donc une tension primaire U1j plus faible. Lorsque le transformateur électrique 18 est utilisé en Suisse, l'organe de réglage 20 comprend cinq ou six positions de réglage.

La valeur Kpos vaut 1 pour la deuxième position P2 de l'organe de réglage 20, c'est-à-dire pour l'établissement de la valeur nominale de la tension primaire. Dans l'exemple d'une tension primaire U1j supérieure de 2,5% à la tension nominale, l'organe de réglage est en première position P1 et la valeur de Kpos vaut par exemple 1,025. Kpos vaut, par exemple, 0,975 pour un organe de réglage en troisième position P3.

La détermination de la valeur Kpos est, par exemple, obtenue à l'aide de la connaissance des tensions nominales primaire correspondant à chaque position de l'organe de réglage, de la tension nominale secondaire, de l'équation [3], et de la mesure des courants primaires I1j et secondaires I2j.

Le calcul du premier terme de l'équation [3] permet d'identifier la position de l'organe de réglage Kpos vérifiant que le rapport entre les tensions primaire U1j et secondaire U2j soient égale au premier terme de l'équation [3] issu des mesures des courants primaire et secondaire.

Une fois la position de l'organe de réglage Kpos connue, le calcul du module de chaque tension primaire U1j est effectué lors de l'étape 130 à l'aide du deuxième logiciel de calcul 68. Ce module est fonction de la position de l'organe de réglage Kpos, du rapport de transformation à vide des tensions nominales primaire et secondaire, de la mesure de chaque tension secondaire U2j, et de la chute de tension calculée lors de l'étape 120.

Finalement, lors d'une étape 140, on calcule le déphasage de chaque tension primaire U1j avec le courant primaire I1j correspondant. Pour cela, on part du principe que le déphasage du côté de l'enroulement primaire 52 ne dépend significativement que du déphasage du courant primaire I1j correspondant par rapport à la tension secondaire mesurée U2j correspondante. Dans la configuration D yn11 du transformateur 18, la relation est donnée par l'équation [4].

Le module et la phase de chaque tension primaire U1j sont ainsi connus.

Le système de détermination 22 selon l'invention permet une mise en oeuvre de la détermination de chaque tension primaire U1j dans un contexte d'utilisation et d'amélioration du réseau existant.

En outre, la mise en place du système de détermination 22 est possible sans coupure de tension grâce, par exemple, à l'utilisation de tores ouvrants en tant que capteurs de courant. Elle ne nécessite par ailleurs aucun accès physique aux parties sous tension du côté primaire du transformateur 18.

La mise en place du système de détermination 22 ne nécessite ni réglage, ni paramétrage particulier tout au long de sa vie de fonctionnement. En particulier, la position de l'organe de réglage 20 du transformateur est automatiquement prise en compte.

Aucun des capteurs de courant et de tension 56A, ..., 59C nécessite un isolement en moyenne tension.

De plus, ce système de détermination 22 permet de calculer la position Kpos de l'organe de réglage 20 du transformateur 18 et de rendre cette information accessible à distance et disponible numériquement. Historiquement, les chargeurs hors charge de transformateurs de distribution sont positionnés lors de l'installation du poste selon les règles propres à chaque distributeur, et la consignation de leur position dans une base de données n'est que rarement garantie. Actuellement, le seul moyen de connaître avec la certitude la position réelle d'un chargeur de prise consiste à se rendre dans le poste pour vérifier de visu.

Cette fonctionnalité de lecture à distance de la position Kpos apporte une solution au problème d'excursion en tension du réseau dans la mesure où elle permet à l'opérateur de réseau d'évaluer à distance la capacité de réglage dont il dispose localement, à l'endroit du problème.

L'homme du métier comprendra que le système et le procédé décrits précédemment dans le cas P=3, P étant le nombre de conducteurs de phases, s'applique pour toute valeur de P, et également P=1, c'est-à-dire dans le cas d'un réseau monophasé.

On conçoit ainsi que le système de détermination 22 selon l'invention, est plus précis et moins coûteux, tout en étant simple d'installation, simple d'utilisation et compatible avec le réseau existant.

## Revendications

**1.** Procédé de détermination d'une tension primaire (U1j) d'un transformateur électrique (18), le transformateur électrique présentant un rapport de transformation à vide et comprenant un enroulement primaire (52) propre à présenter la tension primaire (U1j) entre ses extrémités et à être traversé par un courant primaire (I1), un enroulement secondaire (54) propre à présenter une tension secondaire (U2j) entre ses extrémités et à être traversé par un courant secondaire (I2j), et,

le procédé comprenant les étapes suivantes :

- la mesure de la tension secondaire (U2j) à l'aide d'un capteur de tension (59A, 59B, 59C),
- la mesure du courant primaire (I1j) à l'aide d'un premier capteur de courant (56A, 56B, 56C).

le procédé étant **caractérisé en ce qu'il** comprend en outre les étapes suivantes :

a)- le calcul d'une chute de tension secondaire entre les extrémités de l'enroulement secondaire (54), en fonction de caractéristiques propres du transformateur (18), du facteur de charge du transformateur (18) et du facteur de puissance d'une charge connectée à l'enroulement secondaire (54) en sortie du transformateur (18), la chute de tension secondaire étant exprimée en pourcentage d'une tension nominale à vide associée au transformateur (18) ;

b)- le calcul du module |U1j| de la tension primaire en fonction de la tension secondaire mesurée, de la chute de tension calculée lors de l'étape a) et du rapport de transformation à vide ; et

c)- le calcul du déphasage de la tension primaire (U1j) par rapport au courant primaire (I1j) mesuré en fonction du déphasage de la tension secondaire (U2j) mesurée par rapport au courant primaire (I1j) mesuré.

2. Procédé selon la revendication 1, **caractérisé en ce que** lors de l'étape a) la chute de tension secondaire est calculée selon l'équation suivante :

$$\frac{\Delta U}{U} = (Ur \cos\varphi + Ux \sin\varphi) * n \; + \; \frac{1}{200} * (Ux \cos\varphi \; - \; Ur \sin\varphi) \; * n^2$$

où Ur et Ux représentent les composantes résistive et réactive propres au transformateur (18), n représente le facteur de charge du transformateur (18), et
cos $\varphi$ représente le facteur de puissance de la charge du transformateur (18).

3. Procédé selon la revendication 1 ou 2, **caractérisé en ce que** le transformateur électrique (18) comprend en outre un organe de réglage (20) propre à modifier le rapport de transformation à vide du transformateur (18), et **en ce que**, lors de l'étape b), le module |U1j| de la tension primaire (U1j) est calculé en fonction de la tension secondaire (U2j) mesurée, de la chute de tension calculée lors de l'étape a), du rapport de transformation à vide et de la position de l'organe de réglage (20).

4. Procédé selon la revendication 3, **caractérisé en ce que** lors de l'étape b), le module |U1j| de la tension primaire est calculé selon l'équation suivante :

$$U1j \; = \; Kpos \; * \frac{U1o}{U2o} * \frac{U2j}{1 - \dfrac{\Delta U}{U}}$$

où Kpos est un coefficient dépendant de la position de l'organe de réglage (20), $\dfrac{U1o}{U2o}$ est le rapport de transformation à vide du transformateur (18), U2j est la tension secondaire,

et $\dfrac{\Delta U}{U}$ la chute de tension secondaire calculée lors de l'étape a).

5. Procédé selon l'une des revendications précédentes, **caractérisé en ce que** lors de l'étape c), le déphasage ph(U1j,I1j) entre la tension primaire (U1j) et le courant primaire (I1j) est calculé selon l'équation suivante :

$$ph(U1j,I1j) = \pi - ph(I1j,U2j)$$

où ph(I1j,U2j) est le déphasage mesuré entre le courant primaire (I1j) et la tension secondaire (U2j).

6. Procédé selon l'une des revendications précédentes, **caractérisé en ce qu'il** comprend en outre la mesure du courant secondaire (I2j) à l'aide d'un deuxième capteur de courant (58A, 58B, 58C) et **en ce que**, lors de l'étape b), la position de l'organe de réglage (20) du transformateur (18) est calculée en fonction des courants primaire (I1j) et secondaire (I2j).

**7.** Procédé selon la revendication 6, **caractérisé en ce que** la position de l'organe de réglage (Kpos) est déterminée à l'aide de la connaissance des tensions nominales primaire pour chacune des positions de l'organe de réglage du transformateur, de la tension nominale secondaire, ainsi qu'à l'aide de l'équation suivante :

$$\frac{I2j}{I1j} = \frac{U1j}{U2j}$$

où I1j et I2j sont les courants primaires et secondaires mesurés, U1j et U2j sont les tensions primaires et secondaires, la détermination de la position de l'organe de réglage (20) se faisant par identification de la position (Kpos) permettant d'obtenir le rapport entre les tensions nominales primaire et secondaire, correspondant au second terme de l'équation précédente, le plus proche du rapport entre courants secondaire (I2j) et primaire (I1j) mesurés.

**8.** Système (22) de détermination d'une tension primaire (U1j) d'un transformateur électrique (18), le transformateur électrique (18) présentant un rapport de transformation à vide et comprenant un enroulement primaire (52) propre à présenter la tension primaire (U1j) entre ses extrémités et à être traversé par un courant primaire (I1j), un enroulement secondaire propre à présenter une tension secondaire (U2j) entre ses extrémités et à être traversé par un courant secondaire (I2j), et

le système comprenant :

- un capteur de tension (59A, 59B, 59C) propre à mesurer la tension secondaire (U2j),
- un premier capteur de courant (56A, 56B, 56C) propre à mesurer le courant primaire (I1j),

le système étant **caractérisé en ce qu'il** comprend en outre :

- des premiers moyens de calcul de la chute d'une tension secondaire entre les extrémités de l'enroulement secondaire (54), en fonction de caractéristiques propres du transformateur (18), du facteur de charge du transformateur et du facteur de puissance d'une charge connectée à l'enroulement secondaire (54) en sortie du transformateur (18), la chute de tension secondaire étant exprimée en pourcentage d'une tension nominale à vide associée au transformateur (18) ;
- des deuxièmes moyens de calcul du module |U1j| de la tension primaire (U1j) en fonction de la tension secondaire (U2j) mesurée, de la chute de tension calculée lors de l'étape a) et du rapport de transformation à vide ; et
- des troisièmes moyens de calcul du déphasage de la tension primaire (U1j) par rapport au courant primaire (I1j) mesuré en fonction du déphasage de la tension secondaire (U2j) mesurée par rapport au courant primaire mesuré (I1j).

**9.** Système de détermination selon la revendication 8, **caractérisé en ce que** chaque capteur de courant (56A, 56B, 56C, 58A, 56B, 56C) comporte un tore ouvrant.

**10.** Système de détermination selon l'une des revendications 8 ou 9, **caractérisé en ce que** chaque capteur de courant (56A, 56B, 56C, 58A, 56B, 56C) est relié aux troisièmes moyens de calcul via des moyens de communication radioélectrique.

**11.** Poste de transformation (18) d'un premier courant électrique (I1j) présentant une première tension alternative (U1j) en un deuxième courant électrique (I2j) présentant une deuxième tension alternative (U2j), comprenant :

- un premier tableau (14) comportant au moins un conducteur électrique d'arrivée (26, 28, 30) propre à être relié au réseau électrique (12), le conducteur d'arrivée présentant une tension primaire (U1j),
- un deuxième tableau (16) comportant au moins un conducteur électrique de départ (42, 44, 46), le conducteur de départ présentant une tension secondaire (U2j),
- un transformateur (18) comprenant un enroulement primaire (52) lié au premier tableau (14), et un enroulement secondaire (54) lié au deuxième tableau (16), et
- un système de détermination de la tension primaire (U1j) du transformateur (18),
**caractérisé en ce que** le système de détermination est conforme à l'une quelconque des revendications 8 à 10.

**EP 2 730 929 B1**

**Patentansprüche**

1. Verfahren zum Bestimmen einer Primärspannung (U1j) eines elektrischen Transformators (18), wobei der elektrische Transformator ein Leerlauf-Transformationsverhältnis, eine Primärwicklung (52), die eingerichtet ist, eine Primärspannung (U1j) zwischen ihren Enden zu haben und von einem Primärstrom (I1) durchflossen zu werden, und eine Sekundärwicklung (54) hat, die eingerichtet ist, zwischen ihren Enden eine Sekundärspannung (U2j) zwischen ihren Enden zu haben und von einem Sekundärstrom (I2j) durchflossen zu werden, und wobei das Verfahren die folgenden Schritte aufweist:

   - das Messen der Sekundärspannung (U2j) mit Hilfe eines Spannungssensors (59A, 59B, 59C)
   - das Messen des Primärstroms (I1j) mit Hilfe eines ersten Stromsensors (56A, 56B, 56C),
   wobei das Verfahren dadurch charakterisiert ist, dass es außerdem die folgenden Schritte aufweist:

   a)- das Berechnen eines Abfalls der Sekundärspannung zwischen den Enden der Sekundärwicklung (54) als Funktion spezifischer Eigenschaften des Transformators (18), des Lastfaktors des Transformators (18) und des Leistungsfaktors einer Last, die am Ausgang des Transformators (18) mit der Sekundärwicklung (54) verbunden ist, wobei der Abfall der Sekundärspannung in Prozent einer dem Transformator (18) zugeordneten Leerlaufnominalspannung ausgedrückt wird;
   b)- das Berechnen des Betrags |U1j| der Primärspannung als Funktion der gemessenen Sekundärspannung, des gemäß Schritt a) berechneten Spannungsabfalls und des Leerlauf-Transformationsverhältnisses; und
   c)- das Berechnen der Phasenverschiebung der Primärspannung (U1j) bezüglich des gemessenen Primärstroms (I1j) als Funktion der Phasenverschiebung der gemessenen Sekundärspannung (U2j) bezüglich des gemessenen Primärstroms (I1j).

2. Verfahren gemäß Anspruch 1, dadurch charakterisiert, dass gemäß dem Schritt a) der Abfall der Sekundärspannung gemäß der folgenden Gleichung berechnet wird:

$$\frac{\Delta U}{U} = (Ur\cos\varphi + Ux\sin\varphi) * n + \frac{1}{200} * (Ux\cos\varphi + Ur\sin\varphi) * n^2$$

wobei Ur und Ux die für den Transformator (18) spezifischen resistive Komponente und reaktive Komponente repräsentieren, n den Lastfaktor das Transformators (18) repräsentiert und cos φ den Leistungsfaktor der Last des Transformators (18) repräsentiert.

3. Verfahren gemäß einem der Ansprüche 1 oder 2, dadurch charakterisiert, dass der elektrische Transformator (18) außerdem ein Einstellelement (20) aufweist, dass dazu geeignet ist, das Leerlauf-Transformationsverhältnis des Transformators (18) zu verändern und dadurch, dass gemäß Schritt b) der Betrag |U1j| der Primärspannung (U1j) als Funktion der gemessenen Sekundärspannung (U2j), dem gemäß Schritt a) gemessenen Spannungsabfall, des Leerlauf-Transformationsverhältnisses und der Position des Einstellelements (20) berechnet wird.

4. Verfahren gemäß Anspruch 3, dadurch charakterisiert, dass gemäß Schritt b) der Betrag |U1j| der Primärspannung gemäß der folgenden Gleichung berechnet wird:

$$U1j = Kpos * \frac{Ulo}{U2o} * \frac{U2j}{1 - \frac{\Delta U}{U}}$$

wobei Kpos ein von der Position des Einstellelements (20) abhängiger Koeffizient ist, $\frac{Ulo}{U2o}$ des Leerlauf-Transformationsverhältnis des Transformators (18) ist, U2j die Sekundärspannung ist und $\frac{\Delta U}{U}$ der gemäß Schritt a) berechnete Abfall der Sekundärspannung ist.

5.  Verfahren gemäß einem der vorhergehenden Ansprüche, dadurch charakterisiert, dass gemäß Schritt c) die Phasenverschiebung ph(U1j, I1j) zwischen der Primärspannung (U1j) und dem Sekundärstrom (I1j) gemäß der folgenden Gleichung berechet wird:

$$ph(U1j, I1j) = \pi - ph(I1j, U2j),$$

wobei ph(U1j, Ilj) die zwischen dem Primärstrom (I1j) und der Sekundärspannung (U2j) gemessene Phasenverschiebung ist.

6.  Verfahren gemäß einem der vorhergehenden Ansprüche, dadurch charakterisiert, dass es außerdem das Messen des Sekundärstroms (I2j) mit Hilfe eines zweiten Stromsensors (58A, 58B, 58C) aufweist und dadurch, dass gemäß Schritt b) die Position des Einstellelements (20) des Transformators (18) als Funktion des Primärstromms (I1j) und des Sekundärstroms (I2j) berechnet wird.

7.  Verfahren gemäß Anspruch 6, dadurch charakterisiert, dass die Position des Einstellelements (Kpos) mit Hilfe der Kenntnis der nominalen Primärspannung für jede Position des Einstellelements des Transformators, der nominalen Sekundärspannung sowie mit Hilfe der folgenden Gleichung ermittelt wird:

$$\frac{I2j}{I1j} = \frac{U1j}{U2j}$$

wobei I1j und I2j der gemessene Primärstrom und der gemessene Sekundärstrom sind und U1j und U2j die Primärspannung und die Sekundärspannung sind, wobei die Ermittlung der Position des Einstellelements (20) erfolgt durch Identifikation der Position (Kpos), die es ermöglicht, das Verhältnis zwischen der Primärspannung und der Sekundärspannung, entsprechend dem zweiten Term der vorhergehenden Gleichung, zu erhalten, dass am nächsten am Verhältnis zwischen dem gemessenen Sekundärstrom (I2j) und dem gemessenen Primärstrom (I1j) liegt.

8.  System (22) zum Bestimmen der Primärspannung (U1j) eines elektrischen Transformators (18), wobei der elektrische Transformator ein Leerlauf-Transformationsverhältnis, eine Primärwicklung (52), die eingerichtet ist, eine Primärspannung (U1j) zwischen ihren Enden zu haben und von einem Primärstrom (I1) durchflossen zu werden, und eine Sekundärwicklung (54) hat, die eingerichtet ist, zwischen ihren Enden eine Sekundärspannung (U2j) zwischen ihren Enden zu haben und von einem Sekundärstrom (I2j) durchflossen zu werden, und wobei das System aufweist:

    - eines Spannungssensors (59A, 59B, 59C), geeignet zum Messen der Sekundärspannung (U2j)
    - einen ersten Stromsensor (56A, 56B, 56C), geeignet zum Messen des Primärstroms (I1j),

    wobei das System dadurch charakterisiert ist, dass es außerdem aufweist:

    - erste Mittel zum Berechnen eines Abfalls der Sekundärspannung zwischen den Enden der Sekundärwicklung (54) als Funktion spezifischer Eigenschaften des Transformators (18), des Lastfaktors des Transformators (18) und des Leistungsfaktors einer Last, die am Ausgang des Transformators (18) mit der Sekundärwicklung (54) verbunden ist, wobei der Abfall der Sekundärspannung in Prozent einer dem Transformator (18) zugeordneten Leerlaufnominalspannung ausgedrückt wird;
    - zweite Mittel zum Berechnen des Betrags |U1j| der Primärspannung (U1j) als Funktion der gemessenen Sekundärspannung (U2j), des gemäß Schritt a) berechneten Spannungsabfalls und des Leerlauf-Transformationsverhältnisses; und
    - dritte Mittel zum Berechnen der Phasenverschiebung der Primärspannung (U1j) bezüglich des gemessenen Primärstroms (I1j) als Funktion der Phasenverschiebung der gemessenen Sekundärspannung (U2j) bezüglich des gemessenen Primärstroms (I1j).

9.  System zum Bestimmen gemäß Anspruch 8, dadurch charakterisiert, dass jeder Stromsensor (56A, 56B, 58A, 56B, 56C) einen öffnenden Ringkern aufweist.

10. System zum Bestimmen gemäß einem der Ansprüche 8 oder 9, dadurch charakterisiert, dass jeder Stromsensor (56A, 56B, 56C, 58A, 56B, 56C) mit den dritten Mitteln zum Berechnen über Funkkommunikationsmittel verbunden ist.

11. Station zum Transformieren (18) eines ersten elektrischen Stroms (I1j) mit einer ersten Wechselspannung (U1j) in einen zweiten elektrischen Strom (I2j) mit einer zweiten Wechselspannung (U2j), aufweisend:

- eine erste Schalttafel (14) aufweisend mindestens einem elektrischen Eingangsleiter (26, 28, 30), der dazu geeignet ist, mit dem elektrischen Netz (12) verbunden zu werden, wobei der Eingangsleiter eine Primärspannung (U1j) hat,
- eine zweite Schalttafel (16) aufweisend mindestens einen elektrischen Ausgangsleiter (42, 44, 46), der eine Sekundärspannung (U2j) hat,
- einen Transformator (18) mit einer Primärwicklung (52), die mit der ersten Schalttafel (14) verbunden ist und einer Sekundärwicklung (54), die mit der zweiten Schalttafel (16) verbunden ist und
- ein System zur Bestimmung der Primärspannung (U1j) des Transformators (18),
dadurch charakterisiert, dass das System zum Bestimmen einem der Ansprüche 8 bis 10 entspricht.

## Claims

1. Method for determining a primary voltage (U1j) of a transformer (18), said transformer having a no-load voltage ratio and comprising a primary winding (52) for having the primary voltage (U1j) between its ends and for having a primary current (11) pass through it, a secondary winding (54) for having a secondary voltage (U2j) between its ends and for having a secondary current (12j) pass through it, and
the method comprises the following steps:

• measurement of the secondary voltage (U2j) by means of a voltage sensor (59A, 59B, 59C),
• measurement of the primary current (I1j) by means of a first current sensor (56A, 56B, 56C),

the method being **characterised in that** it additionally comprises the following steps:

a) calculation of a drop in secondary voltage between the ends of the secondary winding (54) as a function of characteristics of the transformer (18) itself, the load factor of the transformer (18) and the power factor of a load connected to the secondary winding (54) at the output of the transformer (18), wherein the drop in secondary voltage is expressed as a percentage of a no-load nominal voltage associated with the transformer (18);
b) calculation of the modulus |U1j| of the primary voltage as a function of the measured secondary voltage, the voltage drop calculated in step a) and the no-load voltage ratio; and
c) calculation of the phase shift of the primary voltage (U1j) in relation to the measured primary current (I1j) as a function of the phase shift of the measured secondary voltage (U2j) in relation to the measured primary current (I1j).

2. Method according to claim 1, **characterised in that** in step a) the drop in secondary voltage is calculated according to the following equation:

$$\frac{\Delta U}{U} = (Ur\ cos\varphi + Ux\ sin\varphi * n + \frac{1}{200} * (Ux\ cos\varphi - Ur\ sin\varphi) * n^2$$

where Ur and Ux represent the resistive and reactive components of the transformer (18) itself, n represents the load factor of the transformer (18) and
cos $\varphi$ represents the power factor of the load of the transformer (18).

3. Method according to claim 1 or 2, **characterised in that** the transformer (18) additionally comprises a control element (20) for modifying the no-load voltage ratio of the transformer (18), and **in that** in step b) the modulus |U1j| of the primary voltage is calculated as a function of the measured secondary voltage (U2j), the voltage drop calculated in step a), the no-load voltage ratio and the position of the control element (20).

4. Method according to claim 3, **characterised in that** in step b) the modulus |U1j| of the primary voltage is calculated according to the following equation:

$$U1j = Kpos * \frac{U1o}{U2o} * \frac{U2j}{1 - \frac{\Delta U}{U}}$$

where Kpos is a coefficient dependent on the position of the control element (20), $\frac{U1o}{U2o}$ is the non-load voltage ratio of the transformer (18), U2j is the secondary voltage, and $\frac{\Delta U}{U}$ j is the drop in secondary voltage calculated in step a).

5. Method according to one of the preceding claims, **characterised in that** in step c) the phase shift ph(U1j, I1j) between the primary voltage (U1j) and the current (I1j) is calculated according to the following equation:

ph(U1j, I1j) = π - ph(I1j, U2j)
where ph(I1j, U2j) is the measured phase shift between the primary current (I1j) and the secondary voltage (U2j).

6. Method according to one of the preceding claims, **characterised in that** it additionally comprises measurement of the secondary current (I2j) by means of a second current sensor (58A, 58B, 58C) and **in that** in step b) the position of the control element (20) of the transformer (18) is calculated as a function of the primary (I1j) and secondary (I2j) currents.

7. Method according to claim 6, **characterised in that** the position of the control element (Kpos) is determined on the basis of knowledge of the primary nominal voltages for each of the positions of the control element of the transformer, the secondary nominal voltage and also by means of the following equation:

$$\frac{I2j}{I1j} = \frac{U1j}{U2j}$$

where I1j and I2j are the measured primary and secondary currents, U1j and U2j are the primary and secondary voltages, wherein the determination of the position of the control element (20) is achieved by identifying the position (Kpos) that enables the relation between the primary and secondary nominal voltages corresponding to the second term of the preceding equation that is closest to the relation between measured secondary (I2j) and primary (I1j) currents to be obtained.

8. System (22) for determining a primary voltage (U1j) of a transformer (18), said transformer having a no-load voltage ratio and comprising a primary winding (52) for having the primary voltage (U1j) between its ends and for having a primary current (11) pass through it, a secondary winding for having a secondary voltage (U2j) between its ends and for having a secondary current (I2j) pass through it, and
the system comprising:

- a voltage sensor (59A, 59B, 59C) for measuring the secondary voltage (U2j),
- a first current sensor (56A, 56B, 56C) for measuring the primary current (I1j), the system being **characterised in that** it additionally comprises:
- first means for calculating the drop in a secondary voltage between the ends of the secondary winding (54) as a function of characteristics of the transformer (18) itself, the load factor of the transformer and the power factor of a load connected to the secondary winding (54) at the output of the transformer (18), wherein the drop in secondary voltage is expressed as a percentage of a no-load nominal voltage associated with the transformer (18);
- second means for calculating the modulus |U1j| of the primary voltage (U1j) as a function of the measured secondary voltage, the voltage drop calculated in step a) and the no-load voltage ratio; and
- third means for calculating the phase shift of the primary voltage (U1j) in relation to the measured primary current (I1j) as a function of the phase shift of the measured secondary voltage (U2j) in relation to the measured primary current (I1j).

9. Determination system according to claim 8, **characterised in that** each current sensor (56A, 56B, 56C, 58A, 58B, 58C) has an opening core.

10. Determination system according to claim 8 or 9, **characterised in that** each current sensor (56A, 56B, 56C, 58A, 58B, 58C) is connected to the third calculation means by radioelectric communication means.

11. Station (18) for transforming a first electrical current (I1j) having a first alternating voltage (U1j) into a second electrical current (I2j) having a second alternating voltage (U2j) comprising:

• a first board (14) having at least one inlet electrical conductor (26, 28, 30) for connection to the power network (12), wherein the inlet conductor has a primary voltage (U1j);
• a second board (16) having at least one outlet electrical connector (42, 44, 46), wherein the outlet conductor has a secondary voltage (U2j),
• a transformer (18) comprising a primary winding (52) connected to the first board (14) and a secondary winding (54) connected to the second board (16) and
• a system for determining the primary voltage (U1j) of the transformer (18), **characterised in that** the determination system is in accordance with any one of claims 8 to 10.

Fig.1

EP 2 730 929 B1

*Fig.2*

EP 2 730 929 B1

```
┌─────────────────────────────┐
│  Mesure de la tension        │        100
│  secondaire                  │
│  U2                          │
└─────────────────────────────┘
              │
              ▼
┌─────────────────────────────┐
│  Mesure des courants         │        110
│  primaires et                │
│  secondaires I1 et I2        │
└─────────────────────────────┘
              │
              ▼
┌─────────────────────────────┐
│  Calcul de la chute de       │  ΔU    120
│  tension                     │  ──    
│                              │   U    
└─────────────────────────────┘
              │
              ▼
┌─────────────────────────────┐
│  Détermination de la         │        125
│  position de                 │
│  l'organe de réglage         │
└─────────────────────────────┘
              │
              ▼
┌─────────────────────────────┐
│  Calcul du module de la      │        130
│  tension                     │
│  primaire U1                 │
└─────────────────────────────┘
              │
              ▼
┌─────────────────────────────┐
│  Calcul du déphasage de la   │        140
│  tension                     │
│  primaire U1 avec le courant │
│  primaire                    │
└─────────────────────────────┘
```

*Fig.3*

**EP 2 730 929 B1**

## RÉFÉRENCES CITÉES DANS LA DESCRIPTION

### Documents brevets cités dans la description

- US 2010061964 A1